# EUROPÄISCHE PATENTSCHRIFT

(11) **EP 0 730 670 B1**
(45) Veröffentlichungstag und Bekanntmachung des Hinweises auf die Patenterteilung: **19.05.1999**
(21) Anmeldenummer: 95900095.1
(22) Anmeldetag: 28.10.1994
(51) Int. Cl.: C23C 16/26, C23C 16/52

(54) **BESCHICHTETER KÖRPER, VERFAHREN ZU DESSEN HERSTELLUNG SOWIE DESSEN VERWENDUNG**
COATED BODY, ITS METHOD OF PRODUCTION AND ITS USE
CORPS REVETU, SON PROCEDE DE FABRICATION ET SON APPLICATION

(30) Priorität: 29.10.1993 CH 3267/93; 29.10.1993 CH 3268/93
(43) Veröffentlichungstag der Anmeldung: 11.09.1996
(73) Patentinhaber: BALZERS AKTIENGESELLSCHAFT, 9496 Balzers (LI)
(72) Erfinder: KARNER, Johann, A-6800 Feldkirch (AT); BERGMANN, Erich, CH-4058 Basel (CH); PEDRAZZINI, Mauro, FL-9492 Eschen (LI); REINECK, Ingrid, S-141 72 Huddinge (SE); SJÖSTRAND, Mats, E., S-164 78 Kista (SE)
(74) Vertreter: Troesch Scheidegger Werner AG
(86) Internationale Anmeldenummer: EP9403562
(87) Internationale Veröffentlichungsnummer: WO9512009

(56) Entgegenhaltungen:
- EP-A- 0 299 752
- EP-A- 0 402 039
- EP-A- 0 469 204
- EP-A- 0 470 531
- EP-A- 0 481 722
- EP-A- 0 491 521
- EP-A- 0 567 124
- PATENT ABSTRACTS OF JAPAN vol. 009, no. 267 (C-310) 24. Oktober 1985 & JP,A,60 114 571 (MITSUBISHI KINZOKU KK) 21. Juni 1985
- PATENT ABSTRACTS OF JAPAN vol. 17, no. 427 (M-1459) 9. August 1993 & JP,A,05 092 305 (MITSUBISHI MATERIALS CORP) 16. April 1993
- PATENT ABSTRACTS OF JAPAN vol. 9, no. 271 (C-311) (1994) 29. Oktober 1985 & JP,A,60 121 271 (MITSUBISHI KINZOKU) 26. Juni 1985
- DATABASE WPI Section Ch, Week 8651, Derwent Publications Ltd., London, GB; Class L03, AN 86-335590 & JP,A,61 251 158 (SUMITOMO ELEC IND KK) 8. November 1986
- PATENT ABSTRACTS OF JAPAN vol. 012, no. 444 (C-545) 22. November 1988 & JP,A,63 166 970 (SEIKO INSTR & ELECTRONICS LTD) 11. Juli 1988
- PATENT ABSTRACTS OF JAPAN vol. 15, no. 275 (C-849) 12. Juli 1991 & JP,A,03 094 062 (SUMITOMO ELECTRIC IND.) 18. April 1991
- PATENT ABSTRACTS OF JAPAN vol. 015, no. 362 (M-1157) 12. September 1991 & JP,A,03 142 104 (ASAHI DAIYAMONDO KOGYO KK) 17. Juni 1991

## Beschreibung

Die vorliegende Erfindung betrifft einen mindestens teilweise beschichteten Körper nach dem Oberbegriff von Anspruch 1 bzw. 2. Sie betrifft im weiteren ein Verfahren zu dessen Herstellung nach dem Oberbegriff von Anspruch 14 bzw. 15 sowie Verwendungen des genannten Körpers bzw. Verfahrens.

Es gehört zur Beschreibung Anhang A.

### Definitionen:

1. Körper aus mehrphasigem Werkstoff:
   Ein mehrphasiger Werkstoff ist ein Werkstoff, der sich aus mehreren Phasen zusammensetzt, die entweder der gleichen Verbindung angehören oder aber verschiedenen Verbindungen. Im Falle verschiedener Verbindungen können die Verbindungen Elemente gemeinsam haben oder auch nicht. Es fallen somit zum Beispiel gehärtete Stähle, Cermets und insbesondere Hartmetalle darunter.
2. Interphase bzw. Übergangszone:
   Wird auf einen Körper aus mehrphasigem Werkstoff eine Diamantbeschichtung aufgebracht, so ergibt sich kein schrittartiger Uebergang vom Grundkörpermaterial in das Diamantbeschichtungsmaterial, sondern ein Uebergang über die sogenannte "Interphase" oder Übergangszone. Diese Interphase, die einige µm breit sein kann, aber auch schmäler, weist Materialanteile des Körperwerkstoffes wie auch der Diamantbeschichtung auf, mit in Richtung senkrecht zur beschichteten Körperoberfläche ändernden Anteilen. Dabei entspricht die Materialzusammensetzung in der Interphase weder derjenigen des Grundkörpers noch derjenigen der Diamantschicht.
   Im Unterschied dazu wird unter einer
3. Zwischenschicht
   eine Schicht verstanden, die weder Grundkörpermaterial noch Diamantbeschichtungsmaterial umfasst.
4. Metalloid:
   Unter Metalloiden werden folgende Elemente verstanden: Nichtmetalle und Halbmetalle, insbesondere B, Si, Ge, S und P.

Zurzeit sind nur wenig Methoden bekannt, Diamantschichten auf Grundkörpern aus mehrphasigen Werkstoffen haftfest abzuscheiden.

Bezüglich der damit einhergehenden Probleme sei verwiesen beispielsweise auf J.D. de Stefani, "Tooling and Production", July 1993, S. 27 ff.

Es ist, um die Diamantschichthaftung zu verbessern, versucht worden, eine einphasige, geschlossene Zwischenschicht, d.h. mindestens einige Atomlagen, aus einem bestimmten Material auf die Oberfläche des Grundkörpers aufzubringen, bevor die Diamantbeschichtung vorgenommen wird. So schlägt beispielsweise die EP-A-0 166 708 zur Erhöhung der Haftfestigkeit der Diamantschicht vor, vor deren Aufbringen eine Haftvermittlungs-Zwischenschicht einzubauen. Dabei wird ein vom Material des Grundkörpers und der Diamantschicht abweichendes Material, wie für eine Zwischenschicht definitionsmässig gefordert, gewählt. Als Zwischenschichtmaterial wird ein Metall der Gruppe IVb bis VIb des periodischen Systems eingesetzt, dabei vorzugsweise Ti, oder ein Carbid, Nitrid, Carbonitrid, Oxicarbid, Oxid oder Borid eines der besagten Metalle oder ein Edelmetall.

Im weiteren wird auf die EP-A-0 384 011 hingewiesen.

Das Aufbringen von Zwischenschichten hat sich für das Erzielen einer guten Haftung bewährt. Für eine gute Verschleissfestigkeit ist aber nicht nur eine gute Haftung gefordert, sondern auch andere Eigenschaften, wie hohe Zähigkeit und hohe Scherfestigkeit. Sowohl die Diamantschicht wie auch der Grundkörper sind üblicherweise so optimiert, dass sie diesen mechanischen Anforderungen genügen. Wird aber zusätzlich eine Zwischenschicht aufgebracht, führt dies zu weit komplizierteren diesbezüglichen Optimierungsproblemen.

Vorsehen einer metallischen Zwischenschicht führt beispielsweise zu einer Zone mit stark vermindertem Scherwiderstand, so dass bei Einsatz so beschichteter Körper als Werkzeuge, insbesondere Schneidewerkzeuge, in den hoch beanspruchten Bereichen, wie an Schneidkanten, bei Beanspruchung rasch Schichtverlust auftritt. Auch für Vorsehen metalloidischer Zwischenschichten gilt ähnliches.

Aus der japanischen Kokai Nr. 5-65646 ist es weiter bekannt, eine bis 100µ starke makroskopische Zwischenschicht zwischen Grundkörpermaterial und Diamantschicht vorzusehen, aus einer intermetallischen Verbindung. Dabei kann die Zwischenschicht als Oberflächenschicht im Grundkörper ausgebildet sein oder auf der Grundkörperoberfläche. Durch eine solche Zwischenschicht werde wiederum die Haftung der Diamantschicht verbessert.

Im weiteren ist es aus den japanischen Kokai 62-61109 bzw. 62-61108 bekannt, die Nukleation einer Diamantschicht von den Oberflächeneigenschaften des Grundkörpers, wie dessen Rauheit oder Reinheit, dadurch unabhängiger zu machen, dass dem Prozessgas geringe Mengen AlCl3 oder TiCl4 beigemischt wird. Damit werden Diamantschichten auf Grundkörpern erzeugt, die sich ohne die erwähnten Zusätze nicht bilden würden. Die erwähnten Schriften behandeln, mit Blick auf die dort zu lösenden Nukleationsprobleme an unterschiedlich gearteten Grundkörperoberflächen, naheliegenderweise die Diamantbeschichtung ein- und mehrphasiger Grundkörper gleichgewichtig und zielen nicht auf die Erhöhung des Verschleisswiderstandes ab, welcher beispielsweise bei diamantbeschichteten Siliciumkörpern kaum von wesentlicher Bedeutung ist, weil, im oben erwähnten Sinne, Silicium als einphasiges Material kaum als im Sinne des Verschleissverhaltens an sich optimiertes Grundkörpermaterial bezeichnet werden kann.

Im weiteren ist es bekannt, zum Beispiel aus der EP-0 519 587, die Grundkörperoberfläche vor dem Diamantbeschichten chemisch zu ätzen. Nachteilig daran ist insbesondere die Versprödung der Grundkörperoberfläche und die schwierige Beherrschbarkeit des Aetzvorganges. Auch ist es bekannt, bei Grundkörpern mit wesentlichem Co-Gehalt, so zum Beispiel aus der US-4 843 039, die Grundkörperoberfläche vor dem Diamantbeschichten an Co zu verarmen.

Aus der JP-A-60-114 571 wird auf einem Grundkörper, der kein Ti enthält, gleichzeitig mit dem Aufbringen einer Diamantschicht, Ti aufgebracht. Dabei wird weiter vorgeschlagen, falls eine homogene Diamantbeschichtung erwünscht sei, mit einem nur geringen Gehalt an Verunreinigung, dies dadurch zu erreichen, dass Ti nur in einer Anfangsphase der Beschichtung zugeführt werde.

Aus der JP-A-5-92305 ist es weiter bekannt, ein im Grundkörpermaterial nicht enthaltenes Element in die Diamantschicht einzubauen, nämlich B. Auch gemäss der JP-A-60-121271 wird vorgeschlagen, als im Grundkörpermaterial nicht vorhandenes Element, Al in die Diamantbeschichtung einzubauen.

Die EP-A-0 491 521 schlägt vor, auf einen Grundkörper zuerst eine innere Schicht durch thermisches Aufsprühen aufzubringen, darnach eine Schicht aus einer Mischung des thermisch aufgesprühten Materials und Diamant und schliesslich darauf die Diamantschicht aufzubauen.

Es ist Aufgabe der vorliegenden Erfindung, Körper eingangs erwähnter Art vorzuschlagen, deren Verschleissverhalten, d.h., kombiniert, insbesondere Haftungs-, Scherwiderstands- und Zähigkeitsverhalten, wesentlich verbessert ist.

Um dies zu erreichen, zeichnen sich die erwähnten Körper nach dem Kennzeichen von Anspruch 1 bzw. 2 aus.

Ist das erwähnte Element weder Element des Grundkörpermaterials noch der Diamantschicht, so ist die erfindungsgemäss eingebrachte Elementenkonzentration per definitionem höher als an einem gleich diamantbeschichteten Grundkörper. Dann, wenn das Anreicherungselement bereits im Grundkörpermaterial vorliegt, ergibt sich die erfindungsgemäss eingefügte Anreicherung durch Vergleich mit dem Konzentrationsverlauf des betrachteten Elementes an einem gleichen Grundkörper, der ohne jegliche Anreicherungsmassnahmen, aber sonst gleich diamantbeschichtet wurde.

Demnach wurde erkannt, dass das Verschleissverhalten, d.h. Kombination insbesondere von Haftungs-, Scherwiderstands- und Zähigkeitsverhalten des erwähnten diamantbeschichteten Körpers aus mehrphasigem Werkstoff dadurch massgeblich verbessert wird, dass in der Interphase, im weiteren "Übergangszone" genannt, eine Elementanreicherung eingebracht wird, mit einer Konzentration, die an mindestens einer Stelle in der Übergangszone höher ist als die Elementenkonzentration, wenn der gleiche Grundkörper gleich diamantbeschichtet wird, aber ohne spezifisch eingebrachte Elementanreicherung.

Es kann vermutet werden, dass, weil, im Unterschied zu bekannten Ansätzen, keine Zwischenschicht zwischen Grundkörper und Diamantschicht eingesetzt wird, sondern die Übergangszone gezielt modifiziert wird, nicht nur die Hafteigenschaften, sondern zusätzlich auch die das Verschleissverhalten massgeblich mitbestimmenden Scherwiderstands- und Zähigkeitseigenschaften positiv beeinflusst werden oder mindestens nicht negativ beeinflusst werden.

In einer bevorzugten Ausführungsvariante wird die Dicke der Diamantschicht zu weniger als 50µm, vorzugsweise zu 2µm bis 30µm, gewählt, beide Grenzen eingeschlossen.

Im weiteren kann an einem erfindungsgemäss beschichteten Körper die Nukleationsdichte der Diamantschicht im wesentlichen von der Elementanreicherung unbeeinflusst gleich sein wie an einem wie erwähnt gleich diamantbeschichteten, gleichen Grundkörper, ohne Anreicherung mit dem Element, als Vergleichsbasis.

Bevorzugterweise beträgt weiter die Dicke der Übergangszone einige µm, beträgt vorzugsweise höchstens 15µm, dabei weiter vorzugsweise höchstens 10µm.

Es kann beim Körper gemäss Anspruch 1 der Konzentrationsverlauf der Elementanreicherung in einem wesentlichen Bereich der Übergangszone mindestens im wesentlichen konstant sein, kann dabei auf dem Konzentrationswert gehalten werden, den er auch im Grundkörper aufweist, oder kann, insbesondere wenn der Anteil dieses Elementes im Grundkörper verschwindend ist, erst ansteigen und dann entlang einem wesentlichen Bereich der Interphase im wesentlichen konstant gehalten sein. Bevorzugterweise liegt aber in der Übergangszone mindestens eine Maximalstelle der Elementanreicherungskonzentration vor.

Im weiteren hat es sich gezeigt, dass die erfindungsgemäss angestrebte Wirkung, nämlich Erhöhung der Verschleissfestigkeit eines diamantbeschichteten Grundkörpers aus einem mehrphasigen Werkstoff, besonders gut erreicht wird, wenn die Elementanreicherung mindestens eine Konzentration aufweist, die um 0,01at%, vorzugsweise um 0,05at%, insbesondere bevorzugterweise um 0,5at%, dabei besonders um 1at% höher ist als die Konzentration desselben Elementes bei der gleichen Diamantbeschichtung des gleichen Grundkörpers ohne Anreicherung.

Es wird auch ein optimiertes Verschleissverhalten dadurch erreicht, dass, im Sinne einer Maximalgrenze, die Elementkonzentration im Bereich der Übergangszone höchstens 50at%, vorzugsweise aber 2 bis 20at%, beide Grenzen eingeschlossen, höher ist als die Elementkonzentration in der Übergangszone an einem gleich diamantbeschichteten gleichen Grundkörper ohne Elementanreicherung.

Dabei haben sich bis heute als Anreicherungselement insbesondere die Metalle Mg, Al, Cu, dabei aber insbesondere Al, bzw. die Metalloide B, Si, Ge, S, P, und zwar jeweils als eine Komponente des Anreicherungselementes oder als das Anreicherungselement selbst bewährt.

Im weiteren kann bevorzugt der Grundkörper als wesentlichen Bestandteil ein oder mehrere Carbide und Cobalt in einer gleichmässig verteilten Mischung umfassen. Dabei kann weiter bevorzugterweise, und in Kombination mit der erfindungsgemässen Elementanreicherung in der Übergangszone, zusätzlich die oberflächennahe Zone im Grundkörper Cobalt-verarmt werden, dabei bevorzugterweise kombiniert mit einer körperseitig an die Zone anschliessenden Co-angereicherten Zone.

Die Elementanreicherung erfolgt mindestens teilweise gleichzeitig mit der Diamantabscheidung.

Damit lässt sich im gleichen Beschichtungsreaktor die Elementanreicherung entweder unmittelbar vor der Diamantabscheidung beginnen und ohne Prozessunterbrechung kontinuierlich in die Diamantabscheidung hinüberführen, oder die Diamantabscheidung erfolgt gleichzeitig mit der Elementanreicherung.

Es wird in einer bevorzugten Art und Weise die Elementanreicherung unmittelbar vor und zu Beginn oder nur zu Beginn der Diamantabscheidung vorgenommen.

An dieser Stelle sei betont, dass sich grundsätzlich alle bekannten Verfahren für die Diamantbeschichtung einsetzen lassen, wie sie zum Beispiel aus "Development of CVD-Diamond Synthesis Techniques", S. Matsumoto, S. 50-58; Proceeding of First International Symposium on Diamond and Diamond-like Films, Proc.Vol. 89-12; The Electrochemical Society, 1989, edit. by J.P. Dismukes, beschrieben sind.

Insbesondere ergibt sich eine relativ einfache Beherrschbarkeit der Elementanreicherung bzw. des Aufbaus der Übergangszone dadurch, dass die Elementanreicherung aus der Gasphase vorgenommen wird, vorzugsweise aus einer metallorganischen oder metalloidorganischen Gasphase. Im Prinzip eignen sich aber bekannte Vakuumbeschichtungsverfahren, wie CVD-Verfahren, PVD-Verfahren oder PECVD-Verfahren (plasma enhanced chemical vapor deposition), für die Elementanreicherung.

In einer bevorzugten Art und Weise wird die Elementanreicherung mittels eines PVD-Verfahrens, vorzugsweise mittels Verdampfens, z.B. mit Einsatz von Elektronenstrahlverdampfen, realisiert oder durch eine plasmachemische Reaktion mit einem Festkörper, wobei besonders einfach als Festkörper eine Keramik eingesetzt wird, wovon mindestens ein Element durch plasmachemische Reaktion in die Prozessatmosphäre gasförmig freigesetzt wird.

Neben PVD-Verfahren eignen sich nämlich auch vorzüglich plasmachemische Reaktionsverfahren, um das Anreicherungselement einzubringen. Dabei kann die plasmachemische Reaktion zum Beispiel durch Zersetzung von metallorganischen oder metalloidorganischen Gasen erfolgen, aber auch durch Reaktion des bei üblichen Diamantabscheidungsverfahren vorhandenen reaktiven atomaren Wasserstoffes mit einem keramischen Festkörper.

Im weiteren besteht eine Ausführungsvariante des erfindungsgemässen Verfahrens darin, dass ein Körper verwendet wird, dessen Material ein oder mehrere Carbide und Co umfasst, wobei in einer weiteren Ausführungsform der Grundkörper-Oberflächenbereich durch Sintern oder durch einen chemischen Aetzprozess, vor der Diamantbeschichtung mit Einbau des Anreicherungselementes, Co-verarmt wird. Die Co-Verarmung an der Oberfläche des Grundkörpers kann, wie erwähnt, durch ein metallurgisches Sinterverfahren realisiert werden, wobei die Tiefe der verarmten Zone im Grundkörper im Bereich von 5 bis 50µm, in bevorzugter Weise im Bereich von 10 bis 20µm, liegt. Dabei ist die Cobalt-verarmte Zone im Grundkörper und nicht in der Übergangszone angesiedelt.

Bei einem besonders bevorzugten Ausführungsbeispiel weist der Grundkörper eine Co-Verarmungszone von 5 bis 50µm Dicke (beide Grenzen eingeschlossen) auf, vorzugsweise von 10 bis 20µm, in Kombination mit einer Co-angereicherten, körperseitig an die Verarmungszone anschliessenden Zone, die 50 bis 500µm dick ist, vorzugsweise 50 bis 150µm dick ist (alle Grenzwerte eingeschlossen). In der Anreicherungszone ist der Co-Gehalt höher als in der Binder-Phase des ursprünglichen, unmodifizierten Grundkörpermaterials.

Bei Realisation der Co-Verarmung durch ein chemisches Aetzverfahren ist die verarmte Zone vorzugsweise dünner als 10µm, bevorzugterweise dünner als 5µm. Dies wiederum betrachtet ohne Übergangszone.

Bezüglich eines besonders geeigneten Diamantabscheidungsverfahrens kann im weiteren auf die EP-A-0 478 909 verwiesen werden, die als Anhang A Teil der vorliegenden Beschreibung bildet.

Die Elementanreicherung in der Übergangszone wird bevorzugterweise dadurch realisiert, dass, mindestens teilweise während der Diamantbeschichtung, das Anreicherungselement verdampft wird und dessen Konzentration in der Prozessatmosphäre open loop gesteuert oder closed loop geregelt wird, indem die Verdampfungsleistung einer Verdampfungsquelle, wie z.B. eines Elektronenstrahlverdampfers für das Element, im Regelkreis als Stellglied gestellt bzw. als Steuerglied eingesetzt wird.

Bei einer weiteren Ausführungsvariante des erfindungsgemässen Herstellverfahrens wird, mindestens teilweise während der Diamantbeschichtung, das Anreicherungselement durch plasmachemische Reaktion mit einem Festkörper in der Prozessatmosphäre eingebracht und dessen Konzentration in der Atmosphäre durch open loop-Steuern oder closed loop-Regeln geführt, indem die Leistung der Plasmaentladung und/oder die Gaszusammensetzung der Beschichtungsatmosphäre gestellt werden.

Dabei kann die Konzentration des Anreicherungselementes in der Beschichtungsatmosphäre emissionsspektroskopisch gemessen werden, als gemessene IST-Grösse in einem Regelkreis zur Führung der Elementenkonzentration in der Prozessatmosphäre oder als Kontrollgrösse für eine Konzentrations-open-loop-Steuerung.

Der erfindungsgemässe Körper eignet sich insbesondere als Werkzeug, dabei insbesondere als spanabhebendes Werkzeug, wie zum Beispiel zum Drehen, Fräsen oder Bohren. Insbesondere sind diese Körper zur Bearbeitung von Nichteisenmetallen, wie z.B. von Aluminiumlegierungen oder von Buntmetallen, und zur Bearbeitung von Nichtmetallen, wie z.B. Plastik, Holz oder Verbundwerkstoffe, geeignet. Ebenso sind die erfindungsgemässen Körper als Bauteile mit hohem Verschleisswiderstand, im besonderen abrasionsfest, vorzüglich geeignet.

Analog eignet sich das erfindungsgemässe Verfahren insbesondere zur Herstellung verschleissresistenter Körper.

Die Erfindung wird anschliessend, zusätzlich zu ihrer Beschreibung im Zusammenhang mit ihren wesentlichsten Aspekten, wie sie auch in den Ansprüchen spezifiziert sind, anhand von Figuren und Beispielen erläutert.

Die Figuren zeigen:
- Fig. 1: eine schematische Darstellung von Grundkörper, Interphase und Diamantschicht zur Erläuterung des Interphasenbegriffes bzw. Übergangszonenbegriffes;
- Fig. 2a: an einem handelsüblichen, mehrphasigen Grundkörper mit erfindungsgemässer Al-Anreicherung in der Interphase, die mittels EPMA (electron probe micro analysis) gemessenen qualitativen Konzentrationsverläufe des Anreicherungselementes Al in der Interphase und der Grundkörper- bzw. Diamantschichtelemente Co, W und C;
- Fig. 2b: Messresultate analog zu Fig. 2a, an einem handelsüblichen Grundkörper, aber mit Co-verarmter und Co-angereicherter Grundkörperzone, erfindungsgemäss diamantbeschichtet unter Al-Anreicherung in der Interphase;
- Fig. 3: eine schematische Darstellung zur Definition der Strahlbreite bei der EPMA-Messung gemäss den Fig. 2a und 2b;
- Fig. 4a: an einem erfindungsgemäss beschichteten Grundkörper mit Al-Elementanreicherung in der Interphase, der auch der Messung gemäss Fig. 2a zugrundeliegt, die mittels EPMA gemessene qualitative Al-Konzentrationsverteilung an einem Querschliff über Diamantschicht, Interphase und Grundkörper;
- Fig. 4b: eine Rasterelektronen-mikroskopische Aufnahme des Querschliffs gemäss Fig. 4a über Grundkörper, Interphase und Diamantschicht bei einer Vergrösserung von 2000;
- Fig. 5: den zeitlichen Verlauf der relativen Al-Dampfkonzentration während der ersten drei Stunden in der Prozessatmosphäre bei einer Gesamtbeschichtungszeit von 10 Stunden. Die Kurve zeigt dabei die relative Emissionsintensität der Aluminiumlinie und, als Referenzsignal, eine Wasserstofflinie;
- Fig. 6: eine schematische Darstellung zur Erläuterung der durchgeführten Tests an erfindungsgemässen und nichterfindungsgemässen Körpern zur Bestimmung und zum Vergleich ihres Verschleisswiderstandes.

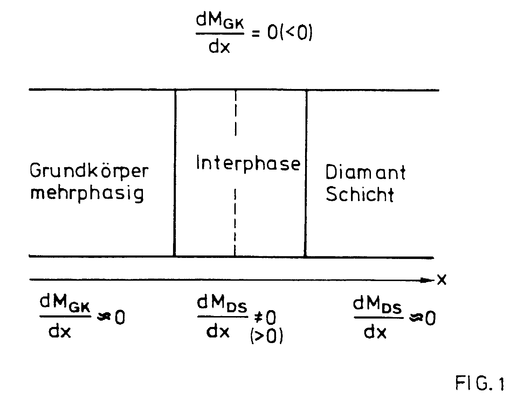

Fig. 1 zeigt schematisch die Verhältnisse an einem diamantbeschichteten, mehrphasigen Grundkörper, wie sie sowohl bei erfindungsgemässer Elementanreicherung wie auch bei konventioneller Beschichtung vorliegen. Im Grundkörperbereich ändert, vom Grundkörperinnern nach aussen in Richtung x fortschreitend, das Grundkörpermaterial M_{GK} im wesentlichen nicht, was in Fig. 1 mit dM_{GK} / dx ≈ 0 angedeutet ist. Desgleichen ändert im Diamantschichtbereich, in besagter Richtung fortschreitend, die Materialzusammensetzung im wesentlichen nicht, was in Fig. 1 mit dM_{GS} / dx ≈ 0 angedeutet ist.

In der dazwischenliegenden Interphase geht grundsätzlich die Materialzusammensetzung von derjenigen des Grundkörpers stetig in diejenige der Diamantschicht über, womit, in besagter Richtung fortschreitend, in der Interphase, wie in Fig. 1 angegeben, sowohl dM_{Gk} / dx ≠ 0 ist, wie auch dM_{DS} / dx ≠ 0 ist. Dabei brauchen in der Interphase diese Bedingungen nicht an jedem Ort x gleichzeitig erfüllt zu sein; es genügt, wenn eine der beiden Bedingungen erfüllt ist. Generell wird, in x-Richtung fortschreitend, innerhalb der Interphase, wie in Fig. 1 in Klammern angegeben, der Anteil des Grundkörpermaterials M_{GK} bzw. mindestens einer wesentlichen Komponente dieses Materials abnehmen und innerhalb der Interphase der Gehalt des Diamantschichtmaterials M_{DS}, in besagter Richtung fortschreitend, zunehmen.

Somit ergibt sich im allgemeinen, und wie in Fig. 1 gestrichelt dargestellt, ein grundkörperseitiger Interphasenbereich, worin das Grundkörpermaterial noch überwiegt, und ein diamantschichtseitiger Interphasenbereich, worin das Diamantschichtmaterial bereits überwiegt.

Mittels eines Verfahrens und einer Anlage, wie sie in der EP-A-478 909 offenbart sind, welche als Teil der vorliegenden Beschreibung in Form von Anhang A beigefügt ist, wurden Hartmetall-Wendeschneidplatten im wesentlichen aus Wolframcarbid und Cobalt diamantbeschichtet, mit erfindungsgemässer Elementanreicherung in der Interphase, wobei in diesem Falle als Anreicherungselement Aluminium eingesetzt wurde.

Der Einbau der Elementanreicherung kann zum Beispiel durch Reaktion des atomaren Wasserstoffes in der Prozessatmosphäre mit einem Keramikfestkörper im Reaktor erfolgen, wodurch das Anreicherungselement in Gasform übergeführt wird und parallel zum Diamantabscheidungsprozess in die Interphase eingebaut wird. Hierzu wird das Element insbesondere unmittelbar vor und/oder während der Anfangsphase des Diamantabscheidungsprozesses in die Prozessatmosphäre freigesetzt.

Anstelle des Einsatzes der erwähnten Aetzreaktion von Keramikfestkörpern im Reaktor kann zum Einbau des Anreicherungselementes ebenso gut jedes andere PVD-Verfahren, wie zum Beispiel thermisches Verdampfen, Elektronenstrahlverdampfen, Lichtbogenverdampfen oder Kathodenzerstäuben, eingesetzt werden. Es kann aber auch durch plasmachemische Reaktion mit gasförmigen Verbindungen des jeweiligen Anreicherungselementes, wie zum Beispiel mit metallorganischen oder metalloidorganischen Verbindungen, das Einbringen des Anreicherungselementes erfolgen.

Als besonders geeignet zur Beherrschung der Anreicherungselementkonzentration in der Gasphase, mindestens teilweise gleichzeitig mit dem Aufbau der Diamantschicht, hat sich die emissionsspektroskopische Messung der Anreicherungselementkonzentration in dieser Gasphase bewährt, wobei das Messresultat als gemessener IST-Wert in einem Regelkreis für besagte Konzentration eingesetzt wird, dabei die je nach eingesetztem Verfahren realisierte Freisetzungsrate des Anreicherungselementes in die Prozessatmosphäre als Stellgrösse eingesetzt wird. Dabei ist es aber durchaus möglich, die emissionsspektroskopische Messung der momentanen Anreicherungskonzentration im Sinne einer Steuerungsführungsgrösse zur open-loop-Führung der erwähnten Konzentration nach einem SOLL-Profil einzusetzen.

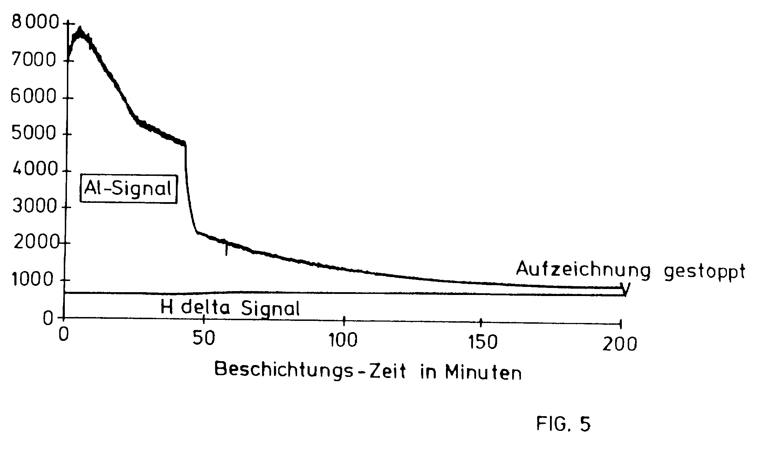

Fig. 5 zeigt den regelungstechnisch oder gesteuert geführten Konzentrationsverlauf des Anreicherungselementes, beispielsweise von Aluminium, über der Zeit im Vergleich zur Konzentration von Wasserstoff. Dabei ist zu erkennen, dass bei der erfindungsgemäss hier beispielsweise gezeigten Elementanreicherung diese im wesentlichen in der ersten Stunde erfolgt, bei einer gesamten Diamantbeschichtungszeit von zehn Stunden.

Mit dem Diamantabscheidungsverfahren, wie in Anhang A beschrieben, wurden verschiedene Grundkörper diamantbeschichtet, unter Einhalt folgender Prozessparameter:

| | |
|---|---|
| Gesamtdruc | 100Pa |
| Gesamtstrom der Entladung | 700A |
| Gasmischung | Ar/H₂/CH₄ = 1 : 1 : 0.005 |
| Körpertemperatur | 810°C |

In der nachfolgenden Tabelle sind die verschiedenen Grundkörper, gegebenenfalls ihre Vorbehandlung, Realisation oder Nichtrealisation der erfindungsgemässen Elementanreicherung und das resultierende Verschleissverhalten zusammengestellt.

| Versuch Nr. | Substrat | Vorbehandlung | Modifikation | Verschl.-verhalten |
|---|---|---|---|---|
| DiD 73 | WC-Co 6% | Co-Verarmung Sintern | Al-Eindampfen | 170 |
| DiD 163 | WC-Co 6% | Co-Verarmung Sintern | Al-Eindampfen | 170 |
| EID 66 | WC-Co 6% | Co-Verarmung Sintern | keine | 10 |
| DiD 53 | WC-Co 3% | chem.geätzt | keine | 0 |
| DiD 169 | WC-Co 3% | chem.geätzt | Al-Eindampfen | 170 |
| EID 92a) | WC-Co 3% | keine | Al-Eindampfen | 170 |
| EID 92b) | WC-Co 6% | keine | Al-Eindampfen | 170 |
| EID 92c) | WC-Co 6% | sandstrahlen | Al-Eindampfen | 170 |

Die Grundkörper sind Wendeschneidplatten. Gemäss den Versuchen Nr. DiD 73, 163, 169 sowie EID 92a)-92c) und alle nach bekannten Diamantbeschichtungsverfahren, ohne Anwendung der erfindungsgemässen Elementanreicherung beschichteten Wendeschneidplatten EID 66 und DID 53, wurden denselben Frästests unterzogen.

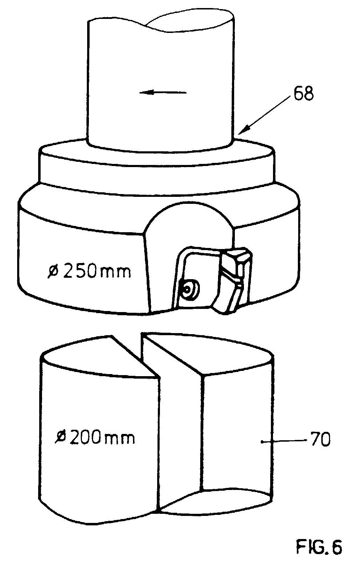

Die Verhältnisse beim durchgeführten Frästest, welcher besonders gut geeignet ist, das Verschleissverhalten des Werkzeuges zu bestimmen, sind in Fig. 6 dargestellt, mit dem Fräskopf 68 und dem bearbeiteten Werkstück 70. Beim vorgenommenen Frästest gelten folgende Parameter:

| | |
|---|---|
| Werkstoff des Werkstückes 70 | Al-4% CU 0,8% Si |
| Werkstückform | Zylinder mit Durchmesser 200mm |
| Schnittgeschwindigkeit | 1500m/min |
| Schnittiefe | 1mm |
| Vorschub | 0,1 bis 0,5mm/min |

eingespannt jeweils eine Wendeschneidplatte.

Als in obiger Tabelle aufgelistete Zahl unter der Rubrik "Verschleissverhalten" erscheint die Anzahl Durchgänge einmaligen, vollständigen Planfräsens des Zylinders. Der Test wurde bei guten Wendeschneidplatten nach 170 Durchgängen abgebrochen. Für eine genauere Beschreibung des Frästests sei auf "CVD-Diamantbeschichtete Zerspanwerkzeuge", I. Reineck, S. Söderberg und M.E. Sjöstrand, VDI-Gesellschaft Produktionstechnik, Neuentwicklungen in der Zerspanungstechnik, S. 55-70, Düsseldorf, 22.-24.9.93, verwiesen.

Die Resultate des Verschleissverhaltens-Tests in Anzahl Durchgängen gehen deutlich aus obiger Tabelle hervor. Während ohne Anwendung der beschriebenen erfindungsgemässen Elementanreicherung, gemäss den Beispielen EID 66 und EID 53, bereits nach null bzw. zehn Durchgängen ein Abplatzen der Diamantschicht erfolgte, halten die entsprechend der Erfindung beschichteten Wendeschneidplatten 170 Durchgänge bis zum Abbruch des Tests stand. Dies nicht nur bei Grundkörpern mit durch Aetzen (EID 169) oder durch Sintern (EID163) Cobalt-verarmter Oberfläche, sondern auch bei nicht vorbehandelten (EID92a, b) oder sandgestrahlten (EID92c) Grundkörperoberflächen.

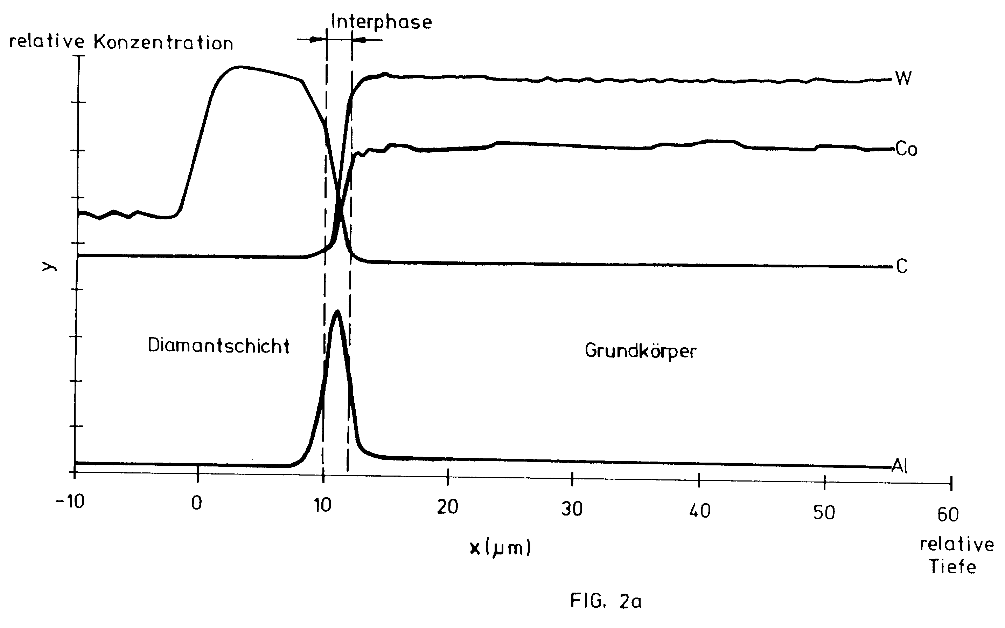

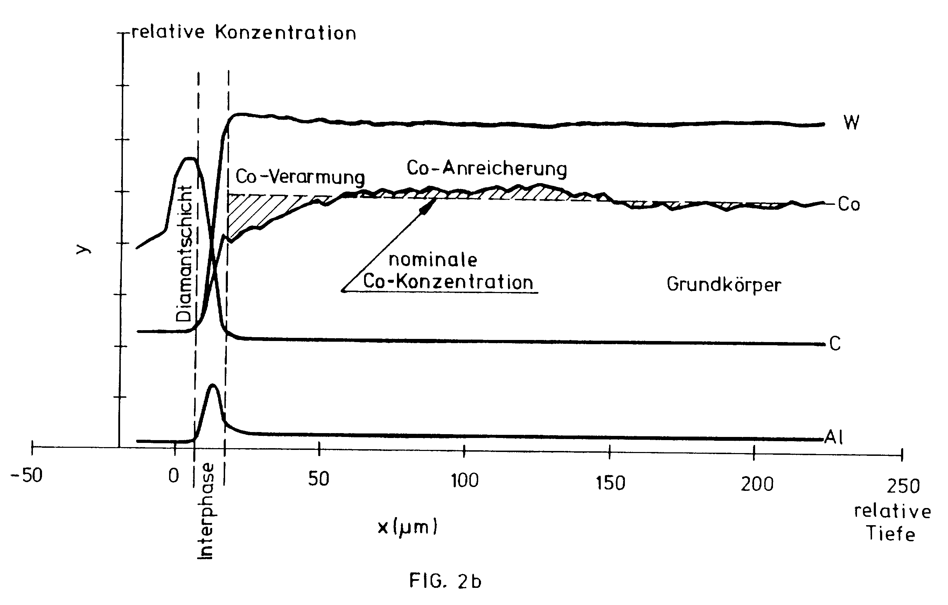

Fig. 2a zeigt die mittels EPMA gemessene qualitative Aluminiumanreicherung bei erfindungsgemässer Ausführung der Elementanreicherung für einen handelsüblichen Hartmetall-Grundkörper ohne Cobaltverarmung, also beispielsweise gemäss dem Versuch EID 92a, 92b, während Fig. 2b, analog, die Aluminiumanreicherung an einem Co-verarmten Grundkörper - zusätzlich mit Co-Anreicherungszone - beispielsweise gemäss den Beispielen DID 73, 163, 169 zeigt. In beiden Fällen ist deutlich ein Maximum der Aluminiumkonzentration im Bereich der Interphase zu erkennen. Es muss auch an dieser Stelle betont werden, dass der weitere Konzentrationsverlauf des Anreicherungselementes ausserhalb der Interphase, d.h. sowohl in den Grundkörper hinein wie auch in die Diamantschicht hinein, für das Erzielen des erfindungsgemäss hohen Verschleisswiderstandes nicht wesentlich ist.

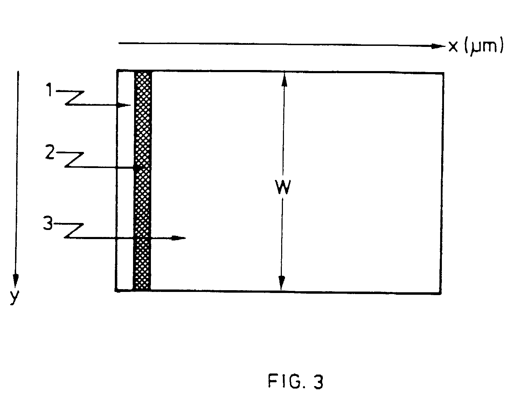

Fig. 3 zeigt eine schematische Darstellung des Messvorgehens für die Messung gemäss den Fig. 2. Dabei bedeuten 1 die Diamantschicht, 2 die Interphase und 3 den Grundkörper. Das Rechteck stellt die Analysefläche dar, wobei der Analysestrahl, mit einer Breite w in y-Richtung von 250µm, in x-Richtung gescanned wird.

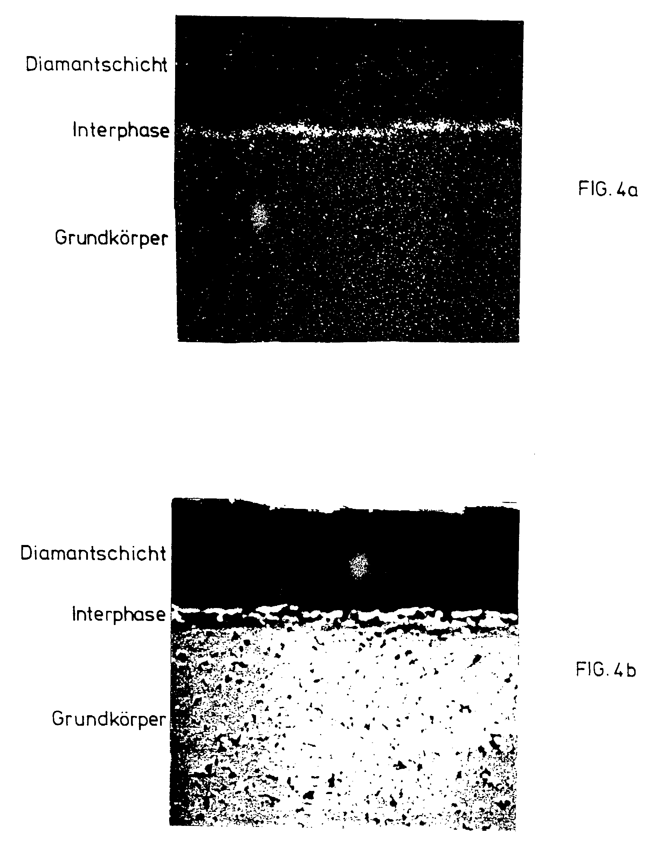

Fig. 4a zeigt die mittels EPMA gemessene Aluminiumverteilung anhand eines Querschliffs in Diamantschicht, Interphase und Grundkörper, beispielsweise gemäss der Konzentrationsverteilung gemäss Fig. 2b. Die Anreicherung des Anreicherungselementes, nämlich Aluminiums, in der Interphase ist deutlich zu erkennen.

Fig. 4b zeigt die zugehörige Rasterelektronen-mikroskopische Aufnahme des Querschliffs über Grundkörper, Interphase und Diamantschicht.

## Patentansprüche

1. Mindestens teilweise beschichteter Körper, umfassend einen Grundkörper aus einem mehrphasigen Werkstoff, unmittelbar darauf eine Diamantschicht, wobei in einer Uebergangszone zwischen Körper und Diamantschicht der Gehalt an Grundkörper-Werkstoff, vom Innern des Grundkörpers nach aussen fortschreitend betrachtet, im wesentlichen stetig abnimmt und der Gehalt des Diamantschichtmaterials im wesentlichen stetig zunimmt, dadurch gekennzeichnet, dass in der Uebergangszone ein bereits im Grundkörper-Werkstoff enthaltenes Element vorhanden ist mit einem Gehalt, der über einen wesentlichen Abschnitt der Uebergangszone mindestens gleich hoch ist wie der Gehalt dieses Elementes im Grundkörper-Werkstoff.

2. Mindestens teilweise beschichteter Körper, umfassend einen Grundkörper aus einem mehrphasigen Werkstoff, unmittelbar darauf eine Diamantschicht, wobei in einer Uebergangszone zwischen Körper und Diamantschicht der Gehalt an Grundkörper-Werkstoff, vom Innern des Grundkörpers nach aussen fortschreitend betrachtet, im wesentlichen stetig abnimmt und der Gehalt des Diamantbeschichtungsmaterials im wesentlichen stetig zunimmt, dadurch gekennzeichnet, dass innerhalb der Uebergangszone der Gehalt eines Elementes des Uebergangszonen-Materials eine Maximalstelle aufweist, von der aus der Gehalt gegen den Grundkörper hin und gegen die Diamantschicht hin über einen wesentlichen Abschnitt der Übergangszone abnimmt.

3. Beschichteter Körper nach Anspruch 1, dadurch gekennzeichnet, dass der Gehalt des Elementes nach Anspruch 2 verläuft.

4. Beschichteter Körper nach einem der Ansprüche 1 bis 3, dadurch gekennzeichnet, dass die Dicke der Diamantschicht weniger als 50µm beträgt, vorzugsweise 2µm bis 30µm beträgt, beide Grenzen eingeschlossen.

5. Beschichteter Körper nach einem der Ansprüche 1 bis 4, dadurch gekennzeichnet, dass die Dicke der Uebergangszone einige µm beträgt, vorzugsweise ≤ 15µm ist, dabei vorzugsweise ≤ 10µm.

6. Beschichteter Körper nach einem der Ansprüche 1, 4 oder 5, sofern nicht auf Anspruch 3 bezogen, dadurch gekennzeichnet, dass der Gehalt des Elementes über den Abschnitt der Übergangszone im wesentlichen konstant ist, vorzugsweise gleich demjenigen ist, den er auch im Grundkörper aufweist.

7. Beschichteter Körper nach einem der Ansprüche 1, 4-6, sofern nicht auf Anspruch 3 bezogen, dadurch gekennzeichnet, dass der Gehalt in der Übergangszone erst ansteigt und dann über den wesentlichen Abschnitt der Übergangszone im wesentlichen konstant ist.

8. Beschichteter Körper nach einem der Ansprüche 1 bis 7, dadurch gekennzeichnet, dass das Element mindestens eines der Metalle Mg, Al, Cu, dabei insbesondere Al umfasst oder durch ein solches gebildet ist oder mindestens eines der Metalloide B, Si, Ge, S, P umfasst oder durch ein solches gebildet ist.

9. Beschichteter Körper nach einem der Ansprüche 1 bis 8, dadurch gekennzeichnet, dass der Grundkörper als wesentlichen Bestandteil ein oder mehrere Carbide und Cobalt in einer gleichmässig verteilten Mischung umfasst und vorzugsweise eine oberflächennahe Zone im Grundkörper Cobalt-verarmt ist, dabei weiter bevorzugterweise eine körperseitig an die Verarmungszone anschliessende Zone Co-angereichert ist.

10. Beschichteter Körper nach Anspruch 9, dadurch gekennzeichnet, dass die Tiefe der verarmten Zone 5 bis 50 µm beträgt, vorzugsweise 10 bis 20 µm.

11. Beschichteter Körper nach einem der Ansprüche 9 oder 10, dadurch gekennzeichnet, dass die angereicherte Zone 50 bis 500 µm dick ist, vorzugsweise 50 bis 150 µm dick.

12. Beschichteter Körper nach einem der Ansprüche 9 bis 11, dadurch gekennzeichnet, dass der Co-Gehalt in der Anreichungszone höher ist als im übrigen Grundkörper, abgesehen von der Verarmungszone.

13. Beschichteter Körper nach einem der Ansprüche 1 bis 12, dadurch gekennzeichnet, dass in der Uebergangszone eine AlCoₓC_{y}-Verbindung vorhanden ist, vorzugsweise zu überwiegendem Anteil.

14. Verfahren zur Herstellung eines beschichteten Körpers nach einem der Ansprüche 1 bis 13, bei dem mindestens zu Beginn der Diamantbeschichtung unmittelbar auf den Grundkörper, in einer Uebergangszone zwischen Körper und Diamantschicht, worin der Gehalt an Grundkörper-Werkstoff, vom Innern des Körpers nach aussen fortschreitend betrachtet, im wesentlichen stetig abnimmt und der Gehalt des Diamantbeschichtungsmaterials im wesentlichen stetig zunimmt, ein weiteres Element eingebaut wird, dadurch gekennzeichnet, dass man mit dem Aufbringen des Diamantbeschichtungsmaterials ein bereits im Material des Grundkörpers vorhandenes Element als weiteres Element miteinbringt.

15. Verfahren zur Herstellung eines beschichteten Körpers nach einem der Ansprüche 1 bis 7, bei dem mindestens zu Beginn der Diamantbeschichtung unmittelbar auf den Grundkörper und in einer Uebergangszone zwischen Körper und Diamantschicht, worin der Gehalt an Grundkörper-Werkstoff, vom Innern des Körpers nach aussen fortschreitend betrachtet, im wesentlichen stetig abnimmt und der Gehalt des Diamantbeschichtungsmaterials im wesentlichen stetig zunimmt, ein weiteres Element eingebaut wird, dadurch gekennzeichnet, dass das Element mit einer Maximalstelle seines Gehaltes in der Uebergangszone eingebaut wird, von der aus der Gehalt gegen den Grundkörper hin und gegen die Diamantbeschichtung hin über einen wesentlichen Abschnitt der Übergangszone abnimmt.

16. Verfahren nach einem der Ansprüche 14 bis 15, dadurch gekennzeichnet, dass im gleichen Beschichtungsreaktor die Elementanreichung entweder unmittelbar vor der Diamantabscheidung begonnen wird und ohne Prozessunterbrechung kontinuierlich in die Diamantabscheidung hinübergeführt wird, oder dass die Diamantabscheidung gleichzeitig mit der Elementanreichung erfolgt.

17. Verfahren nach einem der Ansprüche 14 oder 16, dadurch gekennzeichnet, dass das Element nur unmittelbar vor und zu Beginn oder nur zu Beginn der Diamantabscheidung eingebracht wird.

18. Verfahren nach einem der Ansprüche 14 bis 17, dadurch gekennzeichnet, dass das Element aus der Gasphase eingebracht wird, wobei vorzugsweise ein metallorganisches oder metalloidorganisches Gas verwendet wird.

19. Verfahren nach einem der Ansprüche 14 bis 18, dadurch gekennzeichnet, dass das Element mittels eines PVD-Verfahrens, vorzugsweise mit Einsatz von Verdampfen, wie von Elektronenstrahlverdampfen, eingebracht wird oder durch plasmachemische Reaktion mit einem Festkörper, wobei vorzugsweise als Festkörper eine Keramik eingesetzt wird, wovon das Element durch plasmachemische Reaktion in die Prozessatmosphäre gasförmig freigesetzt wird.

20. Verfahren nach einem der Ansprüche 14 bis 19, dadurch gekennzeichnet, dass als Grundkörpermaterial ein oder mehrere Carbide und Cobalt eingesetzt wird und der Grundkörper-Oberflächenbereich, vorzugsweise durch Sintern oder durch einen chemischen Aetzprozess, vor der Diamantbeschichtung Co-verarmt wird und vorzugsweise körperseitig an den Co-Verarmungsbereich anschliessend ein Co-angereicherter Bereich realisiert wird.

21. Verfahren nach einem der Ansprüche 14 bis 20, dadurch gekennzeichnet, dass, mindestens teilweise während der Diamantbeschichtung, das Element verdampft wird und dessen Konzentration in der Prozessatmosphäre durch Stellen der Verdampfungsleistung einer Verdampfungsquelle für das Element gesteuert oder geregelt wird.

22. Verfahren nach einem der Ansprüche 14 bis 21, dadurch gekennzeichnet, dass, mindestens teilweise während der Diamantbeschichtung, das Anreicherungselement durch plasmachemische Reaktion mit einem Festkörper in die Prozessatmosphäre eingebracht wird und dessen Konzentration durch Steuern oder Regeln geführt wird, durch Stellen der Leistung der Plasmaentladung und/oder der Gaszusammensetzung der Beschichtungsatmosphäre.

23. Verfahren nach einem der Ansprüche 20 oder 22, dadurch gekennzeichnet, dass der Gehalt des Elementes in der Beschichtungsatmosphäre emissionsspektroskopisch gemessen wird, als Messung der IST-Grösse in einem Regelkreis zur Führung der Elementenkonzentration in der Prozessatmosphäre oder als Kontrollgrösse für eine Konzentrationssteuerung.

24. Verfahren nach einem der Ansprüche 14, 16 bis 23, dadurch gekennzeichnet, dass der Gehalt des Elementes in einem wesentlichen Bereich der Uebergangszone im wesentlichen konstant gehalten wird.

25. Verfahren nach einem der Ansprüche 14 bis 24, dadurch gekennzeichnet, dass das Element in die Uebergangszone mit einem Gehalt eingebracht wird, der um 0,01at%, vorzugsweise um 0,05at%, insbesondere bevorzugt um 1at% höher ist als in der sich ohne Einbringen dieses Elementes bildenden Uebergangszone.

26. Verfahren nach einem der Ansprüche 14 bis 25, dadurch gekennzeichnet, dass das Element in die Uebergangszone mit einem Gehalt eingebracht wird, der höchstens 50at%, vorzugsweise 2at% bis 20at% (beide Grenzen eingeschlossen) höher ist als in der sich ohne Einbringen dieses Elementes bildenden Uebergangszone.

27. Verwendung des beschichteten Körpers nach einem der Ansprüche 1 bis 13 als verschleissresistentes Bauteil oder als Werkzeug, dabei insbesondere als spanabhebendes Werkzeug.

28. Verwendung des Verfahrens nach einem der Ansprüche 14 bis 26 zur Herstellung verschleissfester Körper, insbesondere von Werkzeugkörpern.

## Claims

1. At least partly coated body comprising a base body of a multiphase material, directly on this a diamond coating, where in a transition zone between the body and the diamond coating the concentration of base body material, viewed progressively from the inside of the base body to the outside, diminishes essentially steadily and the concentration of the diamond coating material increases essentially steadily, characterised in that in the transition zone an element already contained in the base body material is present at a concentration which over an essential section of the transition zone is at least as high as the concentration of this element in the base body material.

2. At least partly coated body comprising a base body of a multiphase material, directly on this a diamond coating, where in a transition zone between the body and the diamond coating the concentration of base body material, viewed progressively from the inside of the base body to the outside, diminishes essentially steadily and the concentration of the diamond coating material increases essentially steadily, characterised in that within the transition zone the concentration of an element of the transition zone material has a maximum point from which the concentration diminishes over an essential section of the transition zone towards the base body and towards the diamond coating.

3. Coated body according to claim 1, characterised in that the concentration of the element develops according to claim 2.

4. Coated body according to any of claims 1 to 3, characterised in that the thickness of the diamond coating is less than 50 µm, preferably 2 µm to 30 µm inclusive of both limits.

5. Coated body according to any of claims 1 to 4, characterised in that the thickness of the transition zone is a few µm, preferably ≤ 15 µm, preferably ≤ 10 µm.

6. Coated body according to any of claims 1, 4 or 5 where not relating to claim 3, characterised in that the concentration of the element is essentially constant over the section of the transition zone, is preferably the same as that which it has in the base body.

7. Coated body according to any of claims 1, 4 to 6 where not relating to claim 3, characterised in that the concentration in the transition zone first rises and then is essentially constant over an essential section of the transition zone.

8. Coated body according to any of claims 1 to 7, characterised in that the element comprises at least one of the metals Mg, Al, Cu but in particular Al, or is formed from one of these, or comprises at least one of the metalloids B, Si, Ge, S, P or is formed from one of these.

9. Coated body according to any of claims 1 to 8, characterised in that the base body as an essential constituent has one or more carbides and cobalt in an evenly distributed mixture and preferably a zone close to the surface of the base body is cobalt-depleted, where further preferably a zone adjacent to the depletion zone on the body side is Co-enriched.

10. Coated body according to claim 9, characterised in that the depth of the depleted zone is 5 to 50 µm, preferably 10 to 20 µm.

11. Coated body according to any of claims 9 or 10, characterised in that the enriched zone is 50 to 500 µm thick, preferably 50 to 150 µm thick.

12. Coated body according to any of claims 9 to 11, characterised in that the Co-concentration in the enrichment zone is higher than in the remainder of the base body apart from the depletion zone.

13. Coated body according to any of claims 1 to 12, characterised in that in the transition zone an Al-COₓC_{y} compound is present, preferably as the predominant part.

14. Process for production of a coated body according to any of claims 1 to 13, where a further element is added at least at the start of the diamond coating directly on the base body, in a transition zone between the body and the diamond coating in which the concentration of base body material, viewed progressively from the inside of the body to the outside, essentially diminishes steadily and the concentration of the diamond coating material essentially increases steadily, characterised in that together with application of the diamond coating material an element already present in the material of the base body is added as the further element.

15. Process for production of a coated body according to any of claims 1 to 7, where a further element is added at least at the start of the diamond coating directly on the base body and in a transition zone between the body and the diamond coating, where the concentration of base body material, viewed progressively from the inside of the body to the outside, essentially diminishes steadily and the concentration of the diamond coating material essentially increases steadily, characterised in that the element is added with a maximum of its concentration in the transition zone, from which the concentration diminishes over an essential section of the transition zone towards the base body and towards the diamond coating.

16. Process according to any of claims 14 to 15, characterised in that in the same coating reactor the element enrichment is begun either immediately before the diamond precipitation and is transferred continuously to the diamond precipitation without process interruption, or the diamond precipitation takes place simultaneously with the element enrichment.

17. Process according to any of claims 14 or 16, characterised in that the element is added only immediately before and at the start or only at the start of the diamond precipitation.

18. Process according to any of claims 14 to 17, characterised in that the element is added from the gaseous phase, where preferably a metal organic or metalloid organic gas is used.

19. Process according to any of claims 14 to 18, characterised in that the element is added by means of a PVD process, preferably with the use of evaporation such as electron beam evaporation, or by plasma chemical reaction with a solid body where preferably a ceramic is used as the solid body from which the element is released into the process atmosphere in gaseous form by plasma chemical reaction.

20. Process according to any of claims 14 to 19, characterised in that as a base body material one or more carbidesand cobalt are used and the base body surface area, preferably by sintering or by a chemical etching process, is Co-depleted before diamond coating and preferably on the body side a Co-enriched area is created next to the Co-depleted area.

21. Process according to any of claims 14 to 20, characterised in that at least partly during diamond coating, the element is evaporated and its concentration in the process atmosphere is negative feed-back controlled or openloop controlled by adjusting the evaporation power of an evaporation source for the element.

22. Process according to any of claims 14 to 21, characterised in that at least partly during diamond coating, the enrichment element is added to the process atmosphere by plasma chemical reaction with a solid body and its concentration guided by negative feed-back or by open loop control by adjusting the power of the plasma discharge and/or the gas composition of the coating atmosphere..

23. Process according to any of claims 20 or 22, characterised in that the concentration of the element in the coating atmosphere is measured by emission spectroscopy as a measurement of the actual value in a control loop to guide the element concentration in the process atmosphere or as a control parameter for concentration openloop control.

24. Process according to any of claims 14, 16 to 23, characterised in that the concentration of the element is maintained essentially constant in an essential area of the transition zone.

25. Process according to any of claims 14 to 24, characterised in that the element is added to the transition zone with a concentration which is 0.01 at%, preferably 0.05 at% and in particular preferably 1 at% higher than in the transition zone forming without addition of this element.

26. Process according to any of claims 14 to 25, characterised in that the element in the transition zone is introduced with a concentration which is maximum 50 at%, preferably 2 at% to 20 at% (inclusive of both limits) higher than in the transition zone forming without addition of this element.

27. Use of a coated body according to any of claims 1 to 13 as a wear-resistant component or tool, in particular a cutting tool.

28. Use of the process according to any of claims 14 to 26 for production of wear-resistant bodies, in particular tool bodies.

## Revendications

1. Corps au moins partiellement revêtu, comprenant un corps de base en matériau à plusieurs phases, et directement au-dessus, une couche de diamant, étant précisé que dans une zone de transition entre le corps et la couche de diamant, la teneur en matériau-de corps de base diminue de façon globalement continue de l'intérieur du corps de base vers l'extérieur, tandis que la teneur en matériau de couche de diamant augmente de façon globalement continue, caractérisé en ce qu'il est prévu dans la zone de transition un élément déjà contenu dans le matériau de corps de base, avec une teneur qui, sur une section importante de la zone de transition, est au moins aussi élevée que la teneur de cet élément dans le matériau de corps de base.

2. Corps au moins partiellement revêtu, comprenant un corps de base en matériau à plusieurs phases, et directement au-dessus, une couche de diamant, étant précisé que dans une zone de transition entre le corps et la couche de diamant, la teneur en matériau du corps de base diminue de façon globalement continue de l'intérieur du corps de base vers l'extérieur, tandis que la teneur en matériau de couche de diamant augmente de façon globalement continue, caractérisé en ce qu'à l'intérieur de la zone de transition, la teneur d'un élément du matériau de zone de transition présente un point maximal à partir duquel elle va en diminuant en direction du corps de base et en direction de la couche de diamant sur une section importante de la zone de transition.

3. Corps revêtu selon la revendication 1, caractérisé en ce que la teneur de l'élément évolue selon la revendication 2.

4. Corps revêtu selon l'une des revendications 1 à 3, caractérisé en ce que l'épaisseur de la couche de diamant est inférieure à 50 µm et est de préférence de 2 µm à 30 µm inclus.

5. Corps revêtu selon l'une des revendications 1 à 4, caractérisé en ce que l'épaisseur de la zone de transition est de quelques µm, de préférence ≤ 15 µm, de préférence ≤ 10 µm.

6. Corps revêtu selon l'une des revendications 1, 4 ou 5, dans la mesure où on ne se réfère pas à la revendication 3, caractérisé en ce que la teneur de l'élément sur la section de la zone de transition est globalement constante et est de préférence égale à celle qu'il présente dans le corps de base.

7. Corps revêtu selon l'une des revendications 1, 4 à 6, dans la mesure où on ne se réfère pas à la revendication 3, caractérisé en ce que la teneur augmente tout d'abord dans la zone de transition et est ensuite globalement constante sur la section importante de la zone de transition.

8. Corps revêtu selon l'une des revendications 1 à 7, caractérisé en ce que l'élément contient l'un au moins des métaux Mg, Al, Cu, en particulier Al, ou est formé par l'un d'eux, ou contient l'un au moins des métalloïdes B, Si, Ge, S, P ou est formé par l'un d'eux.

9. Corps revêtu selon l'une des revendications 1 à 8, caractérisé en ce que le corps de base contient comme composant essentiel un ou plusieurs carbures et du cobalt dans un mélange à répartition uniforme, et une zone proche de la surface, dans le corps de base, est de préférence appauvrie en cobalt, tandis qu'une zone qui fait suite à la zone appauvrie, côté corps, est de préférence enrichie en Co.

10. Corps revêtu selon la revendication 9, caractérisé en ce que la profondeur de la zone appauvrie est de 5 à 50 µm, de préférence de 10 à 20 µm.

11. Corps revêtu selon la revendication 9 ou 10, caractérisé en ce que la zone enrichie a une épaisseur de 50 à 500 µm et de préférence de 50 à 100 µm.

12. Corps revêtu selon l'une des revendications 9 à 11, caractérisé en ce que la teneur en Co dans la zone enrichie est plus élevée que dans le reste du corps de base, à l'exception de la zone appauvrie.

13. Corps revêtu selon l'une des revendications 1 à 12, caractérisé en ce qu'il est prévu dans la zone de transition un composé Al-COₓC_{y}, de préférence suivant une proportion prépondérante.

14. Procédé pour la fabrication d'un corps revêtu selon l'une des revendications 1 à 13, selon lequel au moins au début de l'application de la couche de diamant directement sur le corps de base, dans une zone de transition entre corps et couche de diamant dans laquelle la teneur en matériau de corps de base diminue de façon globalement continue de l'intérieur du corps vers l'extérieur et la teneur du matériau de revêtement de diamant augmente de façon globalement continue, on intègre un autre élément, caractérisé en ce que, avec l'application du matériau de revêtement de diamant, on introduit comme autre élément un élément déjà présent dans le matériau du corps de base.

15. Procédé pour la fabrication d'un corps revêtu selon l'une des revendications 1 à 7, selon lequel au moins au début de l'application de la couche de diamant directement sur le corps de base, et dans une zone de transition entre corps et couche de diamant dans laquelle la teneur en matériau de corps de base diminue de façon globalement continue de l'intérieur du corps vers l'extérieur et la teneur du matériau de revêtement de diamant augmente de façon globalement continue, on intègre un autre élément, caractérisé en ce que l'élément est intégré avec un point maximal de sa teneur, dans la zone de transition, à partir duquel la teneur va en diminuant en direction du corps de base et en direction du revêtement de diamant sur une section importante de la zone de transition.

16. Procédé selon l'une des revendications 14 à 15, caractérisé en ce que dans le même réacteur d'application de revêtement, l'enrichissement de l'élément commence juste avant le dépôt du diamant et se poursuit jusqu'à celui-ci sans interruption du processus, ou le dépôt de diamant a lieu en même temps que l'enrichissement de l'élément.

17. Procédé selon l'une des revendications 14 ou 16, caractérisé en ce que l'élément est introduit seulement juste avant le dépôt de diamant et au début de celui-ci, ou seulement au début du dépôt de diamant.

18. Procédé selon l'une des revendications 14 à 17, caractérisé en ce que l'élément est introduit à partir de la phase gazeuse, étant précisé qu'on utilise de préférence un gaz organométallique ou organométalloïde.

19. Procédé selon l'une des revendications 14 à 18, caractérisé en ce que l'élément est introduit à l'aide d'un procédé PVD, de préférence avec utilisation d'évaporation, par exemple évaporation par faisceau d'électrons, ou par réaction plasma-chimique avec un corps solide - étant précisé qu'on utilise de préférence une céramique, comme corps solide - à partir duquel l'élément se dégage sous forme gazeuse dans l'atmosphère de traitement grâce à une réaction plasma-chimique.

20. Procédé selon l'une des revendications 14 à 19, caractérisé en ce qu'on utilise comme matériau de corps de base un ou plusieurs carbures et du cobalt, et la zone superficielle du corps de base est appauvrie en Co avant l'application de la couche de diamant, de préférence par frittage ou à l'aide d'un procédé de corrosion chimique, et on réalise de préférence côté corps, à la suite de la zone appauvrie en Co, une zone enrichie en Co.

21. Procédé selon l'une des revendications 14 à 20, caractérisé en ce que, au moins partiellement pendant l'application de la couche de diamant, l'élément est évaporé et sa concentration dans l'atmosphère de traitement est commandée ou ajustée grâce à un réglage de la puissance d'évaporation d'une source d'évaporation pour l'élément.

22. Procédé selon l'une des revendications 14 à 21, caractérisé en ce que, au moins partiellement pendant l'application de la couche de diamant, l'élément enrichi est introduit dans l'atmosphère de traitement grâce à une réaction plasma-chimique avec un corps solide, et sa concentration est guidée par une commande ou un ajustement, grâce au réglage de la puissance de la décharge de plasma et/ou de la composition gazeuse de l'atmosphère d'application de revêtement.

23. Procédé selon la revendication 20 ou 22, caractérisé en ce que la teneur de l'élément dans l'atmosphère d'application de revêtement est mesurée par spectroscopie d'émission, comme mesure de la grandeur réelle dans un circuit de régulation pour le guidage de la concentration de l'élément dans l'atmosphère de traitement, ou comme grandeur de contrôle pour une commande de concentration.

24. Procédé selon l'une des revendications 14, 16 à 23, caractérisé en ce que la teneur de l'élément est maintenue globalement constante dans une partie importante de la zone de transition.

25. Procédé selon l'une des revendications 14 à 24, caractérisé en ce que l'élément est introduit dans la zone de transition avec une teneur qui est supérieure de 0,01 %at, de préférence de 0,05 %at et plus spécialement de 1 %at, par rapport à la zone de transition qui se forme sans introduction de cet élément.

26. Procédé selon l'une des revendications 14 à 25, caractérisé en ce que l'élément est introduit dans la zone de transition avec une teneur qui est supérieure de 50 %at, au maximum, de préférence de 2 %at à 20 %at (inclus), par rapport à la zone de transition qui se forme sans introduction de cet élément.

27. Utilisation du corps revêtu selon l'une des revendications 1 à 13 comme élément de construction résistant à l'usure ou comme outil, en particulier comme outil d'usinage par enlèvement de copeaux.

28. Utilisation du procédé selon l'une des revendications 14 à 26 pour la fabrication de corps résistants à l'usure, en particulier des corps d'outils.
